# EUROPÄISCHE PATENTSCHRIFT

(11) **EP 4 266 007 B1**
(45) Veröffentlichungstag und Bekanntmachung des Hinweises auf die Patenterteilung: **18.12.2024**
(21) Anmeldenummer: 23190460.8
(22) Anmeldetag: 14.02.2022
(51) Int. Cl.: G11C 19/08, G01D 5/14

(54) **SENSORELEMENT ZUR SPEICHERUNG VON UMDREHUNGS- ODER POSITIONSINFORMATIONEN UND SPEICHERSYSTEM MIT EINEM SENSORELEMENT**
SENSOR ELEMENT FOR STORING ROTATION OR POSITION INFORMATION AND STORAGE SYSTEM COMPRISING A SENSOR ELEMENT
ÉLÉMENT DE DÉTECTION POUR STOCKER DES INFORMATIONS DE ROTATION OU DE POSITION ET SYSTÈME DE STOCKAGE COMPRENANT UN ÉLÉMENT DE DÉTECTION

(30) Priorität: 20.05.2021 DE 102021205132
(43) Veröffentlichungstag der Anmeldung: 25.10.2023
(62) Teilanmeldung aus: 22156468.5
(73) Patentinhaber: Dr. Johannes Heidenhain GmbH, 83301 Traunreut (DE)
(72) Erfinder: Schneider, Johannes, 83278 Traunstein (DE)

(56) Entgegenhaltungen:
- US-A1- 2010 301 842

## Beschreibung

### GEBIET DER TECHNIK

Die Erfindung betrifft ein Sensorelement zur Speicherung von Umdrehungsoder Positionsinformationen beispielsweise für eine Winkel- beziehungsweise Längenmesseinrichtung gemäß dem Anspruch 1 und ein Speichersystem mit einem Sensorelement.

Winkelmesseinrichtungen werden beispielsweise als Drehgeber zur Bestimmung der Winkellage zweier relativ zueinander drehbarer Maschinenteile verwendet. Häufig werden zu diesem Zweck so genannte Multi-Turn-Winkelmesseinrichtungen eingesetzt, durch die eine absolute Positionsbestimmung über viele Umdrehungen hinweg möglich ist.

Darüber hinaus sind Längenmesseinrichtungen bekannt, bei denen eine lineare Verschiebung zweier relativ zueinander verschiebbarer Maschinenteile gemessen wird. Insbesondere bei Längenmesseinrichtungen mit vergleichsweise großer Messlänge werden oft mehrere Linearmaßstäbe oder identische Skalen aneinander gereiht. Bei derartigen Längenmesseinrichtungen soll eine absolute Positionsbestimmung möglichst über die gesamte Messlänge möglich sein.

Häufig werden derartige Messeinrichtungen beziehungsweise Messgeräte für elektrische Antriebe zur Bestimmung der Relativbewegung bzw. der Relativlage von entsprechenden Maschinenteilen eingesetzt. In diesem Fall werden die erzeugten Positionswerte einer Folgeelektronik zur Ansteuerung der Antriebe über eine entsprechende Schnittstellenanordnung zugeführt.

Für viele Anwendungen von Positionsmesseinrichtungen, insbesondere von Winkelmess- oder Längenmesseinrichtungen, ist es wichtig zumindest Umdrehungsanzahlen oder Grobpositionen nicht flüchtig zu speichern.

### STAND DER TECHNIK

In der EP 1 740 909 B1 wird ein Sensorelement für einen Umdrehungszähler beschrieben, bei dem Domänenwände entstehen, wobei das Sensorelement eine spezielle spiralförmige Gestalt aufweist.

In der Offenlegungsschrift US 2010/0301842 A1 wird ein Umdrehungszähler offenbart, der Domänenwandleiter aufweist. Diese weisen Schleifen auf, die ins Schleifeninnere gerichtete, spitz zulaufende Ausstülpungen haben. Durch eine Zusatzstromleitbahn kann eine gewünschte Domänenkonfiguration eingeschrieben werden.

Aus der Patentschrift US 4,157,591 ist eine Speichervorrichtung bekannt, bei welcher mit Hilfe eines rotierenden magnetischen Feldes in Domänenleiterstrukturen Informationen gespeichert werden können.

### ZUSAMMENFASSUNG DER ERFINDUNG

Der Erfindung liegt die Aufgabe zugrunde ein Sensorelement zu schaffen, das einen Domänenwandleiter umfasst und das in einer wirtschaftlichen Bauweise eine Initialisierung beziehungsweise einen Reset ermöglicht.

Diese Aufgabe wird erfindungsgemäß durch die Merkmale des Anspruches 1 gelöst.

Demnach betrifft die Erfindung ein Sensorelement zur insbesondere aktiven Speicherung von Umdrehungs- oder Positionsinformationen. Das Sensorelement umfasst einen Domänenwandleiter, der auf einem Substrat angeordnet ist, wobei der Verlauf des Domänenwandleiters kreuzungsfrei ausgestaltet ist. Der Domänenwandleiter beziehungsweise dessen Verlauf weist zudem einen ersten Bereich mit einer positiven Krümmung und einen zweiten Bereich mit einer negativen Krümmung auf. Weiterhin umfasst das Sensorelement eine elektrisch leitende Lage, die auf dem Substrat aufgebracht ist und die relativ zum Domänenwandleiter überlappend und gegenüber diesem elektrisch isoliert angeordnet ist. Die elektrisch leitende Lage weist vier Kontaktierungsstellen auf. Diese sind so angeordnet, dass durch Anlegen einer elektrischen Spannung an zwei Kontaktierungsstellen ein elektrischer Strom in einer ersten Stromrichtung fließt, so dass durch dessen Magnetfeld im Domänenwandleiter Domänenwände erzeugbar sind. Die vier Kontaktierungsstellen sind so angeordnet sind, dass an zwei Paaren von Kontaktierungsstellen eine elektrische Spannung anlegbar ist, so dass der elektrische Strom wahlweise in der ersten Stromrichtung oder in einer zweiten Stromrichtung fließt. Gemäß einer vorteilhaft einfachen Anordnung entspricht die erste Stromrichtung der Richtung einer Verbindungslinie zwischen der ersten Kontaktierungsstelle und der zweiten Kontaktierungsstelle. Die die zweite Stromrichtung kann der Richtung einer Verbindungslinie zwischen der dritten Kontaktierungsstelle und der vierten Kontaktierungsstelle entsprechen. Erfindungsgemäß ist die erste Stromrichtung orthogonal zur zweiten Stromrichtung orientiert.

Die elektrisch leitende Lage ist elektrisch isoliert in einer Richtung orthogonal zur Ebene des Substrats versetzt gegenüber dem Domänenwandleiter angeordnet. Die elektrisch leitende Lage überdeckt also elektrisch isoliert den Domänenwandleiter vollständig oder nur teilweise. Insbesondere kann der Domänenwandleiter auf einer isolierenden Schicht aufgebracht sein, wobei auf der genüberliegenden Seite der isolierenden Schicht die elektrisch leitende Lage vollflächig aufgebracht ist.

Unter dem Begriff aktive Speicherung ist eine Speicherung zu verstehen, für die das betreffende Sensorelement keine elektrische Hilfsenergie benötigt.

Mit Vorteil ist der Verlauf des Domänenwandleiters bezüglich einer Achse achsensymmetrisch ausgestaltet. Dabei kann die Achse um einen Winkel relativ zur ersten Stromrichtung geneigt ausgerichtet sein, beziehungsweise kann die Stromrichtung mit einem Winkel schräg zur Achse verlaufen. Insbesondere ist der Winkel, den die erste Stromrichtung und die Achse einschlie-ßen, größer als 10° und kleiner als 60° (10° < ß < 60°), mit Vorteil größer als 15° und kleiner als 50° (15° < ß < 50°). Die Achse und die erste Stromrichtung in der elektrisch leitenden Lage schließen also beispielsweise einen Winkel zwischen 10° und 60° ein, wobei hier der kleinere der Supplementwinkel gemeint ist.

Domänenwandleiter sind im Zusammenhang mit der vorliegenden Erfindung insbesondere Leiterspuren beziehungsweise Leiterbahnen oder Nanodrähte, welche aus einem magnetisierbaren Material bestehen. Information kann in Form von gegensätzlich magnetisierten Regionen (Domänen) in den Domänenwandleitern gespeichert werden. Die Domänen sind durch so genannte Domänenwände getrennt, die durch Magnetfelder verschoben werden können, wobei sich die Positionen der Domänen ändern. Zum Bestimmen ihrer Position sind Ausleseelemente angeordnet, an denen die Domänen beziehungsweise Domänenwände vorbeigeschoben werden. Domänenwandleiter können demnach funktional betrachtet auch als eine Art Schieberegister angesehen werden.

Vorteilhafterweise ist der Verlauf des Domänenwandleiters geschlossen umlaufend ausgestaltet. Zudem kann der Verlauf des Domänenwandleiters auch stetig ausgestaltet sein.

Der Verlauf des Domänenwandleiters bildet eine zusammenhängende Kurve und weist weder einen Sprung noch eine Spitze, Knick oder eine sonstige Unstetigkeitsstelle auf. Unter dem Begriff stetiger Verlauf ist also ein Verlauf des Domänenwandleiters zu verstehen, der gleichmäßig ohne abrupte Richtungsänderungen ausgestaltet ist. Mathematisch ausgedrückt ist also der Verlauf des Domänenwandleiters über seine gesamte Länge stetig und insbesondere differenzierbar, so dass also an jedem Punkt des Verlaufes des Domänenwandleiters eine eindeutige Tangente erzeugbar ist. Insbesondere weist der Domänenwandleiter über seinen Verlauf nur Krümmungsradien auf, die größer als 0,005 mm, insbesondere größer als 0,02 mm mit Vorteil größer als 0,03 mm sind.

Unter dem kreuzungsfreien Verlauf des Domänenwandleiters ist insbesondere zu verstehen, dass sich der Domänenwandleiter in seinem Verlauf nicht kreuzt aber auch nicht in unterschiedlichen Lagen sich kreuzend übereinander geführt ist.

Unter der Krümmung ist die Richtungsänderung entlang des Verlaufes des Domänenwandleiters auf dem insbesondere ebenen Substrat zu verstehen. Bei einem geraden Verlauf ist die Krümmung gleich null, weil sich die Verlaufsrichtung nicht ändert. Sofern die Krümmung ungleich null ist, kann man für den Verlauf des Domänenwandleiters die Krümmung mit Vorzeichen bezüglich einer Orientierung des Normalenbündels der Verlaufs-Kurve definieren. Die Krümmung ist positiv, wenn sie sich in Richtung des Einheitsnormalenvektorfeldes krümmt und negativ, wenn sie sich in die entgegengesetzte Richtung krümmt. Beispielsweise kann der erste Bereich mit der positiven Krümmung als ein konvexer Bereich bezeichnet werden während dann der zweite Bereich mit der negativen Krümmung als ein konkaver Bereich bezeichnet werden kann. Mathematisch ausgedrückt weist also der Verlauf des Domänenwandleiters insbesondere mindestens einen Wendepunkt auf.

Gemäß einer vorteilhaften Variante weist das Sensorelement weiterhin Ausleseelemente auf, durch die (an der jeweiligen Position der Ausleseelemente) der lokale Magnetisierungszustand des Domänenwandleiters bestimmbar ist. Durch die Ausleseelemente ist somit jeweils ein Magnetisierungszustand des Domänenwandleiters bestimmbar. Die Ausleseelemente sind bezüglich des Domänenwandleiters ortsfest angeordnet.

In weiterer Ausgestaltung der Erfindung ist der Domänenwandleiter in einer Schicht zwischen zumindest einem der Ausleseelemente und dem Substrat angeordnet. Alternativ oder ergänzend ist zumindest eines der Ausleseelemente in einer Schicht zwischen dem Substrat und dem Domänenwandleiter angeordnet.

Mit Vorteil sind die Ausleseelemente als GMR- oder TMR-Sensoren ausgestaltet.

Das Sensorelement kann mehrere Domänenwandleiter aufweisen. In diesem Fall weisen die mehreren Domänenwandleiter unterschiedliche Anzahlen von ersten Bereichen oder unterschiedliche Anzahlen von zweiten Bereichen auf. So kann also beispielsweise das Sensorelement einen ersten Domänenwandleiter und einen zweiten Domänenwandleiter aufweisen, wobei der erste Domänenwandleiter eine erste Anzahl von ersten Bereichen aufweist und der zweite Domänenwandleiter eine zweite Anzahl von ersten Bereichen aufweist.

Vorteilhafterweise sind die unterschiedlichen Anzahlen, also die Anzahl der ersten Bereiche des ersten Domänenwandleiters und die Anzahl der ersten Bereiche des zweiten Domänenwandleiters teilerfremd. Bekanntlich ist unter dem Begriff teilerfremd zu verstehen, dass für die betreffenden Anzahlen (natürliche Zahlen) keine natürliche Zahl außer der Eins existiert, die beide Zahlen teilt.

Gemäß einem weiteren Aspekt umfasst die Erfindung ein Speichersystem, welches ein Sensorelement, ein Bauelement und einen Stützmagnet aufweist. Das Bauelement umfasst eine Magnetanordnung und ist in einer ersten Richtung relativ zum Domänenwandleiter bewegbar ausgestaltet. Der Stützmagnet ist relativ zum Sensorelement unbeweglich angeordnet, insbesondere so, dass sich das Sensorelement zwischen der Magnetanordnung und dem Stützmagnet befindet. Alternativ ist der Stützmagnet bezogen auf die erste Richtung neben der Magnetanordnung am Bauelement relativ zum Sensorelement beweglich angeordnet. Weiterhin ist der Stützmagnet so konfiguriert, dass der Domänenwandleiter durch das Magnetfeld des Stützmagneten in Überlagerung mit dem induzierten Magnetfeld der elektrisch leitenden Lage initialisierbar ist.

Das Bauelement kann beispielsweise als eine Trommel mit einer Winkelskalierung oder als ein Längenmaßstab ausgestaltet sein.

Durch die Bewegung der Magnetanordnung in der ersten Richtung relativ zum Domänenwandleiter wird eine Verschiebung von magnetischen Domänen beziehungsweise von Domänenwänden bewirkt.

Mit Vorteil ist der Stützmagnet so angeordnet, dass eine Verbindungslinie zwischen dessen Nordpol und dessen Südpol in einer zweiten Richtung orientiert ist, wobei die zweite Richtung so orientiert ist, dass diese eine Komponente orthogonal zur ersten Richtung aufweist. Insbesondere verläuft die Verbindungslinie in einer Ebene oder in einer Fläche parallel zum Substrat.

Sowohl die Magnete der Magnetanordnung als auch der Stützmagnet sind insbesondere als Permanentmagnete ausgestaltet.

Mit Vorteil umfasst das Sensorelement ein insbesondere ebenes Substrat und der Domänenwandleiter ist als eine Leiterbahn auf dem Substrat ausgestaltet.

In weiterer Ausgestaltung der Erfindung beträgt die Breite des Domänenwandleiters weniger als 1000 nm, insbesondere weniger als 500 nm mit Vorteil weniger als 300 nm.

Die Dicke beziehungsweise Schichtdicke des Domänenwandleiters beträgt vorteilhafterweise weniger als 200 nm, insbesondere weniger als 150 nm, insbesondere weniger als 60 nm.

Mit Vorteil weist das Substrat eine Glasschicht und / oder eine Siliziumschicht auf. Insbesondere wenn das Substrat eine Siliziumschicht aufweist, kann das Sensorelement als ein Teil eines CMOS-Chips aufgebaut sein.

Mit Vorteil sind das Sensorelement und der Stützmagnet in einem gemeinsamen Gehäuse angeordnet.

Mit Vorteil ist das von der Magnetanordnung erzeugte Magnetfeld bezüglich einer Achse, die parallel zur ersten Richtung verläuft, asymmetrisch ausgestaltet. Diese Betrachtung gilt für eine beliebige gedachte Achse, welche parallel zur ersten Richtung verläuft.

Vorteilhaft ist in weiterer Ausgestaltung der Erfindung das von der Magnetanordnung erzeugte Magnetfeld bezüglich einer Achse, die parallel zu einer zweiten Richtung verläuft, symmetrisch ausgestaltet. Dabei ist die zweite Richtung orthogonal zur ersten Richtung orientiert.

Die Achse, die parallel zur ersten Richtung verläuft und die Achse, die parallel zu einer zweiten Richtung verläuft, liegen insbesondere in einer Ebene, welche parallel zum Substrat orientiert ist.

In weiterer Ausgestaltung des Speichersystems ist die Magnetanordnung als ein Magnetarray ausgestaltet, welches Magnete aufweist, deren Pole in der ersten Richtung versetzt zueinander angeordnet sind.

Mit Vorteil ist der Verlauf des Domänenwandleiters achsensymmetrisch ausgestaltet. Insbesondere kann die betreffende Symmetrieachse parallel zur zweiten Richtung beziehungsweise in der zweiten Richtung verlaufen.

Der Domänenwandleiter weist in der ersten Richtung eine Ausdehnung auf und zwei Magnetpole weisen einen Mittenabstand auf, wobei die Ausdehnung kleiner ist als der Mittenabstand. Hier ist insbesondere die maximale Ausdehnung des Domänenwandleiters in der ersten Richtung zu verstehen. Der Mittenabstand kann insbesondere der Abstand zwischen den wirksamen Mitten der Magnete sein. Beispielsweise kann im Fall von zylindrischen Stabmagneten der Mittenabstand als der Abstand zwischen den Längsachsen der zylindrischen Stabmagnete gesehen werden.

Das Speichersystem ist so ausgestaltet, dass dieses zumindest zwei Domänenwände aufweist, wobei auch Ausgestaltungen mit vier oder mehr Domänenwänden eingesetzt werden können.

Das Speichersystem kann in Verbindung mit einer Winkelmesseinrichtung verwendet werden, wo insbesondere Umdrehungsanzahlen gespeichert werden. Alternativ kann das Speichersystem beziehungsweise das Sensorelement im Zusammenhang mit einem linearen Maßstab eingesetzt werden. Der Maßstab kann insbesondere ein erstes Maßstabsteil und ein zweites Maßstabsteil umfassen. Das erste Maßstabsteil und das zweite Maßstabsteil können etwa entlang der ersten Richtung aneinandergereiht angeordnet sein, so dass eine vergleichsweise große Messlänge erreichbar ist. In der Praxis können auch durchaus mehr als nur zwei Maßstabsteile aneinandergereiht angeordnet sein. Entlang der ersten Richtung zueinander versetzt sind dann Magnetanordnungen vorgesehen. Durch das Sensorelement ist es möglich entsprechende Positionsinformationen zu speichern, so dass feststellbar ist welches der Maßstabsteile gerade abgetastet wird.

Vorteilhafte Ausbildungen der Erfindung entnimmt man den abhängigen Ansprüchen.

Weitere Einzelheiten und Vorteile des erfindungsgemäßen Sensors ergeben sich aus der nachfolgenden Beschreibung von Ausführungsbeispielen anhand der beiliegenden Figuren.

### KURZE BESCHREIBUNG DER ZEICHNUNGEN

Es zeigen die
- Figur 1a: eine Draufsicht auf ein Sensorelement,
- Figur 1b: eine Seitenansicht auf ein Sensorelement,
- Figur 2: eine Detailansicht auf einen Domänenwandleiter,
- Figur 3: einen Magneten einer Magnetanordnung,
- Figur 4: eine Draufsicht auf die Magnetanordnung gemäß einem ersten Ausführungsbeispiel,
- Figur 5: eine Seitenansicht auf ein Bauteil mit der Magnetanordnung,
- Figur 6: eine Draufsicht auf das Bauteil und das Sensorelement,
- Figur 7: eine schematische Ansicht des Domänenwandleiters, eines Stützmagneten und der Magnetanordnung in einer ersten Relativposition zueinander,
- Figur 8: eine schematische Ansicht des Domänenwandleiters, des Stützmagneten und der Magnetanordnung in einer zweiten Relativposition zueinander,
- Figur 9: eine schematische Ansicht des Domänenwandleiters, des Stützmagneten und der Magnetanordnung in einer dritten Relativposition zueinander,
- Figur 10: eine schematische Ansicht des Domänenwandleiters, des Stützmagneten und der Magnetanordnung in einer vierten Relativposition zueinander,
- Figur 11: eine schematische Ansicht des Domänenwandleiters, des Stützmagneten und der Magnetanordnung in einer fünften Relativposition zueinander,
- Figur 12: eine schematische Ansicht des Domänenwandleiters, des Stützmagneten und der Magnetanordnung in einer sechsten Relativposition zueinander,
- Figur 13: eine schematische Ansicht des Domänenwandleiters, des Stützmagneten und der Magnetanordnung in einer siebten Relativposition zueinander,
- Figur 14: eine schematische Ansicht des Domänenwandleiters, des Stützmagneten und der Magnetanordnung in einer achten Relativposition zueinander,
- Figur 15: eine schematische Ansicht des Domänenwandleiters, des Stützmagneten und der Magnetanordnung in einer neunten Relativposition zueinander,
- Figur 16: eine schematische Ansicht des Sensorelements mit einem weiteren Domänenwandleiter und der Magnetanordnung gemäß einem zweiten Ausführungsbeispiel
- Figur 17: eine schematische Ansicht des Domänenwandleiters in einer ersten Phase eines Initialisierungs- beziehungsweise Reset-Prozesses,
- Figur 18: eine schematische Ansicht des Domänenwandleiters in einer zweiten Phase des Initialisierungs- beziehungsweise Reset-Prozesses,
- Figur 19: eine schematische Ansicht des Domänenwandleiters in einer dritten Phase des Initialisierungs- beziehungsweise Reset-Prozesses,
- Figur 20: eine Draufsicht auf die Magnetanordnung gemäß einem dritten Ausführungsbeispiel,
- Figur 21: eine schematische Ansicht des Domänenwandleiters, des Stützmagneten und der Magnetanordnung gemäß dem dritten Ausführungsbeispiel in einer ersten Relativposition zueinander
- Figur 22: eine schematische Ansicht des Domänenwandleiters in einer weiteren Phase eines Initialisierungs- beziehungsweise Reset-Prozesses,
- Figur 23: eine schematische Ansicht des Domänenwandleiters nach der weiteren Phase eines Initialisierungs- beziehungsweise ResetProzesses,
- Figur 24: eine Seitenansicht auf ein Bauteil mit der Magnetanordnung und einem Stützmagneten gemäß einem vierten Ausführungsbeispiel.

### BESCHREIBUNG DER AUSFÜHRUNGSFORMEN

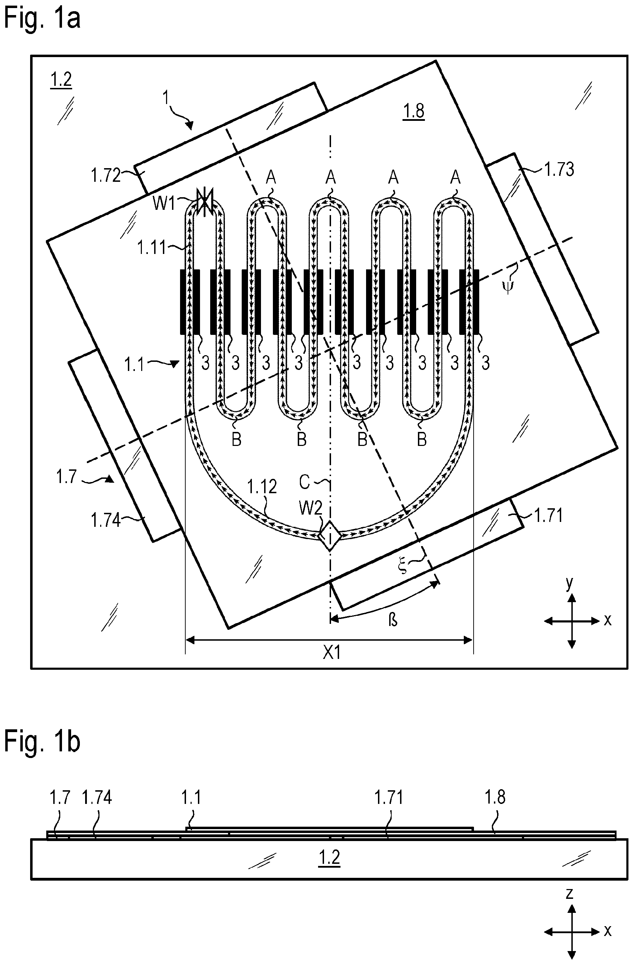

In der Figur 1a ist ein Sensorelement 1 dargestellt, das einen Domänenwandleiter 1.1 und ein Substrat 1.2 umfasst. Im vorgestellten Ausführungsbeispiel weist das Substrat 1.2 eine mechanisch tragende Glasschicht auf, wobei das Substrat 1.2 eben ausgestaltet ist. Alternativ kann das Substrat 1.2 eine Siliziumschicht aufweisen, wobei dann das Sensorelement 1 als ein Teil eines CMOS-Chips ausgestaltet sein kann. Das Sensorelement 1 weist einen Schichtaufbau auf, der im Folgenden vereinfacht folgendermaßen beschrieben werden kann (siehe auch die Figur 1b): Auf dem Substrat 1.2, ist eine elektrisch leitende Lage 1.7 aufgebracht, die hier als eine lediglich wenige µm-Dicke Kupfer-Schicht ausgestaltet ist. Diese elektrisch leitende Lage 1.7 weist eine erste Kontaktierungsstelle 1.71, eine zweite Kontaktierungsstelle 1.72, eine dritte Kontaktierungsstelle 1.73 und eine vierte Kontaktierungsstelle 1.74 auf.

Auf der leitenden Lage 1.7 befindet sich eine elektrisch isolierende Schicht 1.8. Im vorgestellten Ausführungsbeispiel bedeckt die leitenden Lage 1.7 vollflächig die elektrisch isolierende Schicht 1.8 auf der dem Domänenwandleiter 1.1 abgewandten Seite. Der Domänenwandleiter 1.1 in Form einer Leiterbahn ist auf der isolierenden Schicht 1.8 aufgebracht. Die elektrisch leitende Lage 1.7 ist vollflächig unterhalb des Domänenwandleiters 1.1 angeordnet, so dass die elektrisch leitende Lage 1.7 bezüglich des Domänenwandleiters 1.1 überlappend angeordnet ist. Durch den Begriff überlappend wird zum Ausdruck gebracht, dass sich bezogen auf eine dritte Richtung z (Figur 1b) die elektrisch leitende Lage 1.7 und der Domänenwandleiter 1.1 übereinander gestapelt, wenn auch getrennt durch die dünne isolierende Schicht 1.8, angeordnet sind. Durch die isolierende Schicht 1.8 ist der Domänenwandleiter 1.1 gegenüber der leitenden Lage 1.7 elektrisch isoliert.

Alternativ kann der Schichtaufbau invers ausgebildet sein, das heißt, dass der Domänenwandleiter 1.1 auf dem Substrat 1.2 aufgebracht ist und auf dem Domänenwandleiter 1.1 die isolierende Schicht 1.8 und darauf wiederum die elektrisch leitende Lage 1.7.

Der Domänenwandleiter 1.1 umfasst ein weichmagnetisches Material beispielsweise eine Ni-Fe-Legierung. Der Domänenwandleiter 1.1 umfasst einen ersten Abschnitt 1.11, in dem der Domänenwandleiter 1.1 in vergleichsweise engen Schleifen verläuft und einen zweiten Abschnitt 1.12, in dem der Domänenwandleiter 1.1 in einem Bogen mit relativ großem Radius verläuft. Der erste Abschnitt 1.11 und der zweite Abschnitt 1.12 grenzen unmittelbar aneinander, so dass der Verlauf des Domänenwandleiters 1.1 geschlossen umlaufend ausgestaltet ist. Der Domänenwandleiter 1.1 ist bezüglich einer Achse C, die senkrecht zu einer ersten Richtung x und parallel zu einer zweiten Richtung y orientiert ist, symmetrisch ausgestaltet. Der Domänenwandleiter 1.1 weist in der ersten Richtung x eine Breite X1 auf.

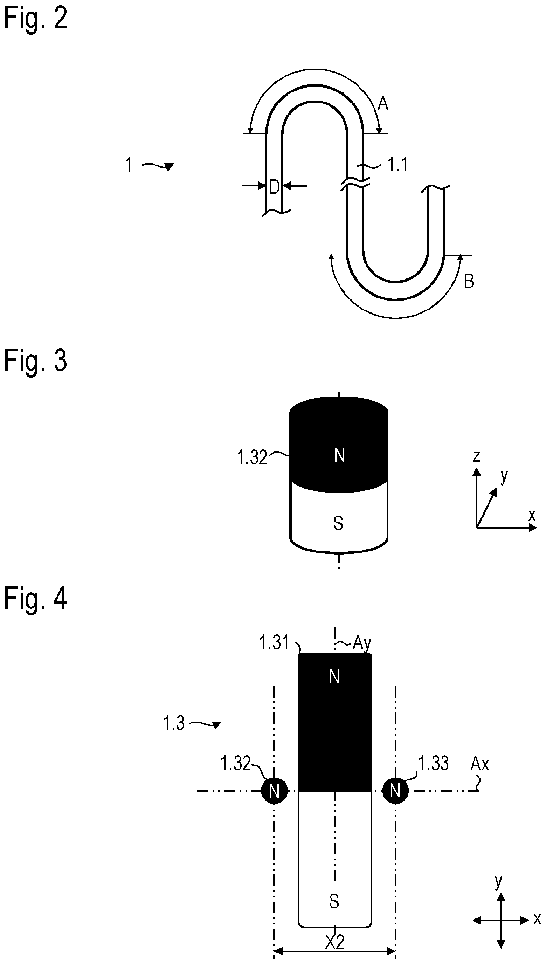

In der Figur 2 ist ein Ausschnitt des Domänenwandleiters 1.1 gezeigt. Darin ist deutlich zu sehen, dass der Domänenwandleiter 1.1 in seinem Verlauf einen ersten Bereich A mit einer positiven Krümmung und einen zweiten Bereich B mit einer negativen Krümmung aufweist. Mit anderen Worten ausgedrückt: würde man dem Verlauf des Domänenwandleiters 1.1 folgen, so würde man sowohl auf einen Abschnitt mit einer Rechtskrümmung als auch auf einen Abschnitt mit einer Linkskrümmung treffen. Im Verlauf des ersten Abschnitts 1.11 folgt auf einen ersten Bereich A mit einer positiven Krümmung ein zweiter Bereich B mit einer negativen Krümmung und darauf wieder ein erster Bereich A usw., wobei im vorgestellten Ausführungsbeispiel sich zwischen den ersten Bereichen A und den zweiten Bereichen B Bereiche mit geradlinigem Verlauf des Domänenwandleiters 1.1 befinden. Im zweiten Abschnitt 1.12 wechselt das Vorzeichen der Krümmung nicht. Im vorgestellten Ausführungsbeispiel ist die Krümmung beziehungsweise der Krümmungsradius dort konstant ausgestaltet.

In einem Schichtaufbau auf dem Substrat 1.2 befinden sich in der Nähe des Domänenwandleiters 1.1 gemäß der Figur 1 Ausleseelemente 3, die beispielsweise GMR-Sensoren oder TMR-Sensoren sein können, mit deren Hilfe der Magnetisierungszustand des dazu benachbarten Domänenwandleiters 1.1 festgestellt werden kann.

Wenn ein relativ zum Domänenwandleiter 1.1 bewegtes Magnetfeld geeignet auf den Domänenwandleiter 1.1 einwirkt, verschieben sich Domänenwände W1, W2 innerhalb des Domänenwandleiters 1.1 beziehungsweise entlang des Domänenwandleiters 1.1. Zur Bildung eines geeigneten Magnetfeldes wird eine Magnetanordnung 1.3 (Figur 4) verwendet, die im vorgestellten Ausführungsbeispiel als ein Magnetarray ausgestaltet ist, das aus mehreren (Permanent-) Magneten 1.31 bis 1.33 besteht.

Ein erster Magnet 1.31 der Magnetanordnung 1.3 ist so angeordnet, dass die Magnetisierung parallel zur zweiten Richtung y vorliegt, beziehungsweise der Nordpol des ersten Magneten 1.31 bezüglich der zweiten Richtung y zu dessen Südpol versetzt angeordnet ist. Ein zweiter Magnet 1.32 der Magnetanordnung 1.3 ist in der ersten Richtung x mit einem Abstand ½·X2 versetzt zum ersten Magneten 1.31 angeordnet. Ein dritter Magnet 1.33 ist gegenüber liegend versetzt zum ersten Magneten 1.31 in der ersten Richtung x platziert. Im vorgestellten Ausführungsbeispiel sind der zweite Magnet 1.32 und der dritte Magnet 1.33 identisch ausgestaltet. Demnach sind die Magnete 1.32, 1.33 als zylindrische Körper ausgestaltet, wobei die magnetischen Pole entlang der längsten Symmetrieachse im Sinne eines Stabmagneten angeordnet sind. Beispielhaft für den zweiten Magnet 1.32 und den dritten Magnet 1.33 ist in der Figur 3 der zweite Magnet 1.32 dargestellt.

Der Domänenwandleiter 1.1 weist gemäß der Figur 1 in der ersten Richtung x eine Ausdehnung X1 auf. Der Abstand X2 zwischen den Mitten des ersten Magneten 1.31 und des zweiten Magneten 1.32 ist so dimensioniert, dass die Ausdehnung X1 kleiner ist als der Abstand X2, X1<X2 (bezogen auf den Mittenabstand der ersten und des zweiten Magneten 1.31, 1.32).

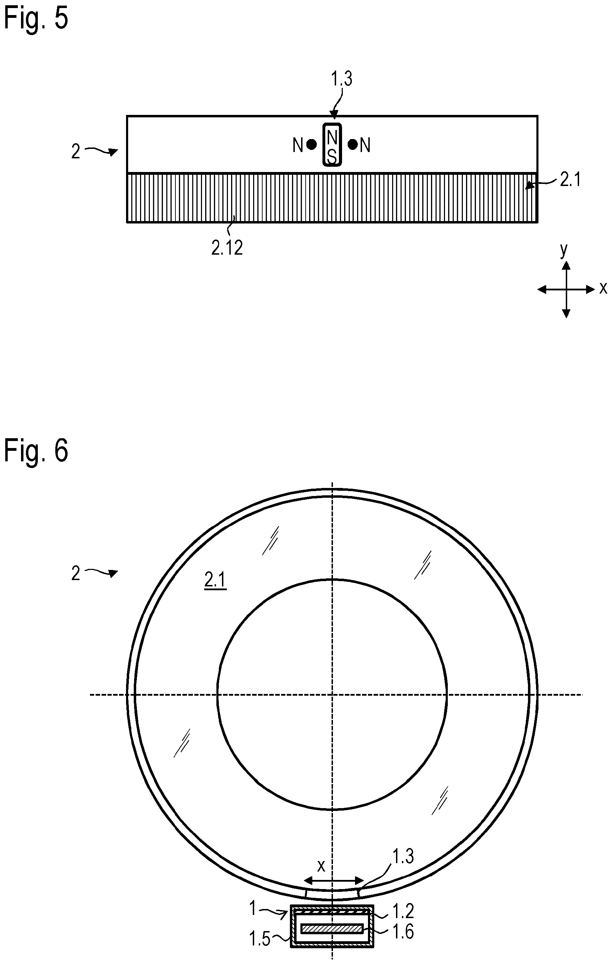

Die Magnetanordnung 1.3 wird üblicherweise an einem Bauteil 2 beziehungsweise an einer Maßverkörperung fixiert. Gemäß dem Ausführungsbeispiel weist das Bauteil 2 eine im Wesentlichen ringförmige Trommel 2.1 (siehe Figuren 5, 6) auf. An deren Außenumfang ist die Magnetanordnung 1.3, bestehend aus dem ersten, zweiten und dritten Magneten 1.31, 1.32, 1.33 montiert. In der zweiten Richtung y also in axialer Richtung dazu versetzt ist im vorgestellten Ausführungsbeispiel eine feine Skala 2.12 umlaufend auf der Trommel 2.1 aufgebracht. Alternativ kann die Magnetanordnung 1.3 auch am Innenumfang einer Trommel beziehungsweise einer Hohlwelle angeordnet sein. Es können neben dem zweiten Magnet 1.32 und dem dritten Magnet 1.33 noch weitere Magnete platziert werden, die eine Homogenisierung des Gesamtmagnetfeldes bewirken. Diese Maßnahme reduziert die Störanfälligkeit des Speichersystems im Hinblick auf äußere Magnetfelder und erlaubt größere Abstandstoleranzen zwischen dem Bauteil 2 und dem Sensorelement 1.

Gemäß der Figur 6 befindet sich mit radialem Luftspalt gegenüber der Trommel 2.1 insbesondere der Magnetanordnung 1.3 das Sensorelement 1, also der Domänenwandleiter 1.1 mit dem Substrat 1.2 innerhalb eines Gehäuses 1.5. Das Gehäuse 1.5 ist im vorgestellten Ausführungsbeispiel ortsfest, während das Bauteil 2 mit der Magnetanordnung 1.3 drehbar gelagert ist, so dass sich die Magnetanordnung 1.3 bei Drehung des Bauteils 2 in der ersten Richtung x (beziehungsweise entgegengesetzt) relativ zum Sensorelement 1 bewegt. Die Skala 2.12 kann beispielsweise durch eine optische Abtastung, welche ebenfalls im Gehäuse 1.5 untergebracht ist, decodiert werden.

Weiterhin befindet sich gemäß dem ersten Ausführungsbeispiel im Gehäuse 1.5 ein Stützmagnet 1.6, der relativ zum Sensorelement 1 unbeweglich angeordnet ist. Das Sensorelement 1 ist unmittelbar gegenüber der dazu beweglichen Magnetanordnung 1.3 angeordnet und der Stützmagnet 1.6 hinter dem Sensorelement 1, so dass das Sensorelement 1 zwischen der Magnetanordnung 1.3 und dem Stützmagnet 1.6 angeordnet ist. Der erste Magnet 1.31 ist so magnetisiert, dass die Verbindungslinie zwischen dessen Nordpol und dessen Südpol parallel zur zweiten Richtung y beziehungsweise parallel zur Achse C orientiert ist. Der Stützmagnet 1.6 ist so angeordnet, dass dessen Magnetisierung antiparallel zur Magnetisierung des ersten Magneten 1.31 ausgerichtet ist. Demnach verläuft die Verbindungslinie zwischen dem Nordpol und dem Südpol des Stützmagneten 1.6 auch parallel zur zweiten Richtung y, jedoch sind die Polausrichtungen entgegengesetzt (in den Figuren ist der Nordpol des ersten Magneten 1.31 oben und der Nordpol des Stützmagneten 1.6 unten).

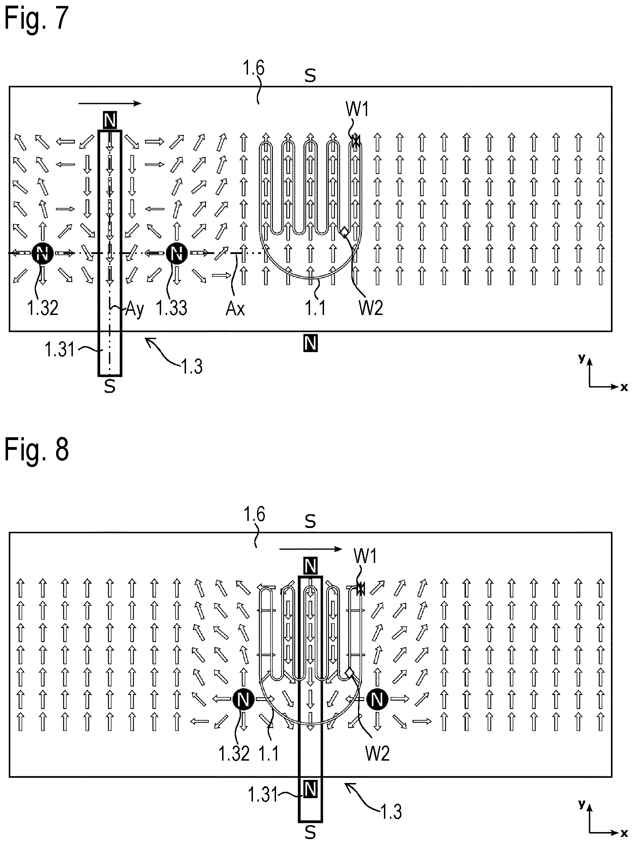

In der Figur 7 sind als Prinzipbild die Magnetanordnung 1.3 sowie der Domänenwandleiter 1.1 mit dem dahinter liegenden Stützmagneten 1.6 in einer ersten Stellung zueinander gezeigt. Durch eine Vielzahl von Pfeilen, soll das Magnetfeld dargestellt werden. In der ersten Stellung befinden sich die Domänenwände W1, W2 in den Positionen gemäß der Figur 7, wobei (wie durch die Symbole dargestellt) die erste Domänenwand W1 eine so genannte head-to-head-Domänenwand ist und die zweite Domänenwand W2 eine so genannte tail-to-tail-Domänenwand.

Das von der Magnetanordnung 1.3 erzeugte Magnetfeld ist bezüglich einer Achse Ax (Figuren 4 und 7), die parallel zur ersten Richtung x verläuft, asymmetrisch ausgestaltet. Dagegen ist das von der Magnetanordnung erzeugte Magnetfeld 1.3 bezüglich einer Achse Ay, die parallel zu einer zweiten Richtung y verläuft, symmetrisch ausgestaltet. Dabei ist die zweite Richtung orthogonal zur ersten Richtung orientiert.

Wenn sich nun die Magnetanordnung 1.3 in der ersten Richtung x gemäß dem Pfeil in der Figur 7 relativ zum Domänenwandleiter 1.1 (und damit auch relativ zum Substrat 1.2 und zum Stützmagnet 1.6) bewegt, wirkt auf den Domänenwandleiter 1.1 ein sich quasi drehendes Magnetfeld. Infolgedessen verschieben sich die Positionen der Domänenwände W1, W2. Das Verschiebefeld wird dadurch erzeugt, dass die Magnetanordnung 1.3 am Domänenwandleiter 1.1 vorbeigeführt wird, wobei das Magnetfeld der Magnetanordnung 1.3 vom Magnetfeld des Stützmagneten 1.6 überlagert wird.

In der Figur 8 ist der Domänenwandleiter 1.1 in einer weiteren Stellung gezeigt, wobei dort das Magnetfeld gegenüber der ersten Stellung in der ersten Richtung x verlagert ist. Dementsprechend haben die Domänenwände W1, W2 ihre Positionen verändert.

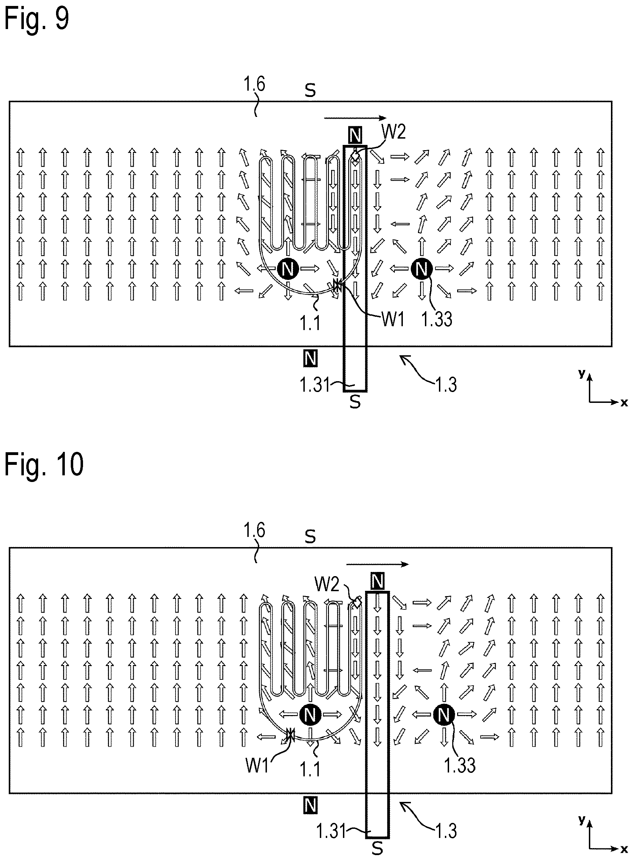

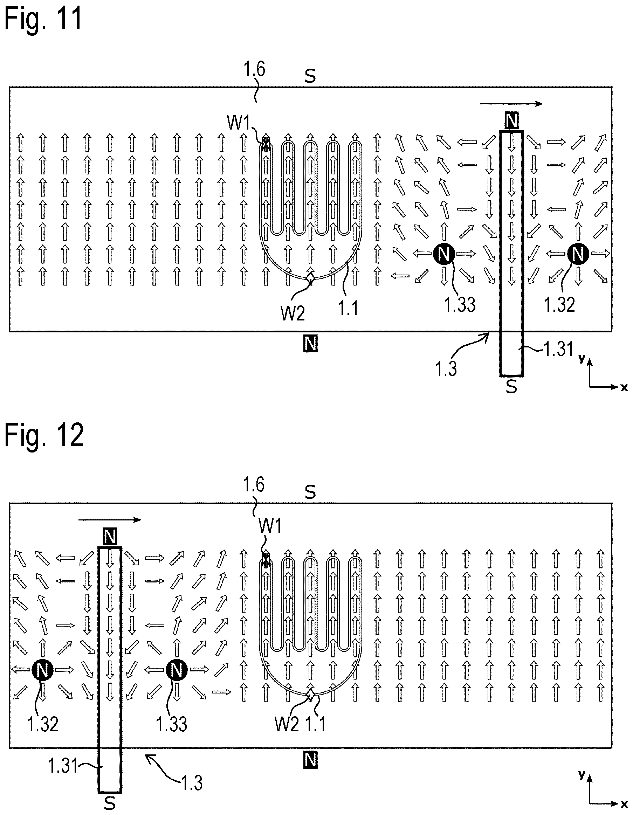

Analog dazu werden infolge einer weiteren Verschiebung der Magnetanordnung 1.3 relativ zum Domänenwandleiter 1.1 entlang der ersten Richtung x (Figuren 9, 10, 11) die Positionen der Domänenwände W1, W2 weiter verschoben. Die Positionen der Domänenwände W1, W2 gemäß der Figur 11 beinhalten beispielsweise die Information, dass die Trommel 2.1 beziehungsweise das Bauteil 2 im Vergleich zur Anordnung der Figur 7 so weit bewegt worden ist, dass die Magnetanordnung 1.3 vollständig den Domänenwandleiter 1.1 passiert hat, was beispielsweise nach der Vollendung einer ersten Umdrehung der Fall ist. Insbesondere durch die Magnetfelder des ersten und des zweiten Magneten 1.32, 1.33 wird ein Verschieben der Domänenwände W1, W2 über den zweiten Abschnitt 1.12 hinweg, in dem der Domänenwandleiter 1.1 in einem Bogen mit relativ großem Radius verläuft, erreicht.

Bei einer weiteren Bewegung beziehungsweise Drehung des Bauteils 2 in die gleiche Richtung verändern sich die Positionen der Domänenwände W1, W2 zunächst nicht mehr, weil sich der Domänenwandleiter 1.1 stets im Einfluss des Magnetfeldes des Stützmagneten 1.6 befindet, wobei der Stützmagnet 1.6 relativ zum Sensorelement 1 unbeweglich angeordnet ist.

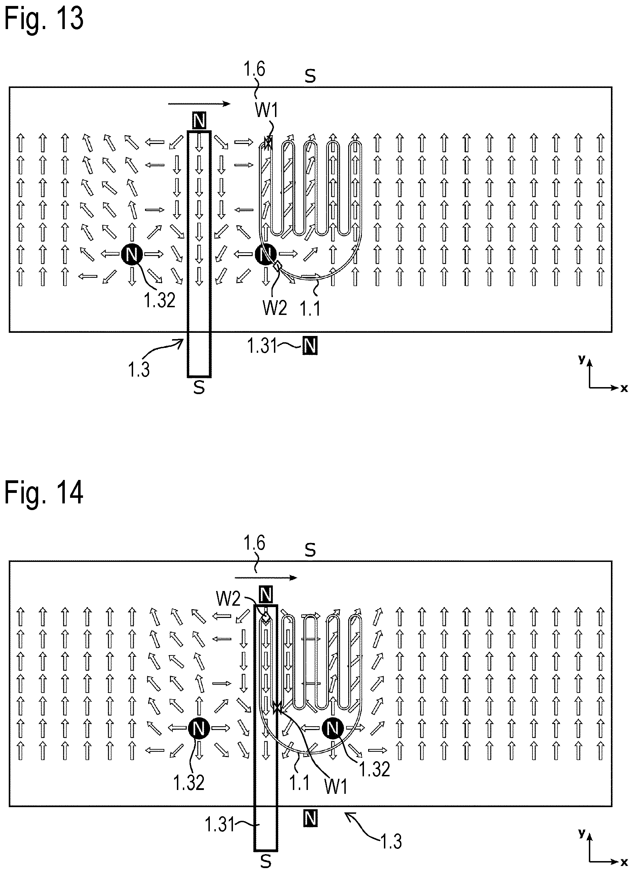

Im vorgestellten Ausführungsbeispiel soll sich die Trommel 2.1 beziehungsweise das Bauteil 2 in der gleichen Richtung (ersten Richtung x) weiter drehen, dementsprechend sind in den Figuren 12 bis 15 je nach Positionierung der Magnetanordnung 1.3 relativ zum Domänenwandleiter 1.1 beziehungsweise zum Sensorelement 1 verschiedene Positionen der Domänenwände W1, W2 dargestellt.

Nach jeder Vorbeifahrt der Magnetanordnung 1.3 am Sensorelement 1 beziehungsweise nach jeder Umdrehung des Bauteils 2 hat sich die Domänenwand W1 jeweils zu einem benachbarten ersten Bereich A des Domänenwandleiters 1.1 weiter bewegt. Entsprechend hat sich die Domänenwand W2 nach jeder Umdrehung von einem zweiten Bereich B zu einem benachbarten zweiten Bereich B des Domänenwandleiters 1.1 weiter bewegt oder sie befindet sich im zweiten Abschnitt 1.12, in dem der Domänenwandleiter 1.1 in einem Bogen mit relativ großem Radius verläuft. Wenn der Ausgangspunkt auf dem Bogen mit dem relativ großen Radius ist, wird die Domänenwand W2 in einen Bogen im zweiten Bereich B bewegt. Bei einer Anordnung gemäß der Figur 1 würden entsprechend fünf aufeinander folgende Vorbeifahrten, beziehungsweise Umdrehungen in einer Richtung zählbar sein.

Die Magnetisierungsrichtungen innerhalb von Abschnitten des Domänenwandleiters 1.1 und damit die Grobpositionen der Domänenwände W1, W2 können durch die Ausleseelemente 3 detektiert werden. Auf diese Weise ist eine Zählung von Umdrehungen beziehungsweise eine Speicherung der Umdrehungsinformation in einer Winkelmesseinrichtung möglich, auch wenn keine Hilfsenergie nutzbar ist. Dies ist beispielsweise wichtig, wenn bei einem Stromausfall eine Welle etwa durch Gewichtbelastung bewegt wird. Die Domänenwände W1, W2 werden im Übrigen drehrichtungsabhängig verschoben, so dass das Sensorelement 1 zuverlässig bei Anwendungen eingesetzt werden kann, die beide Drehrichtungen zulassen.

Für die Funktion des Speichersystems ist es wichtig, dass auf den Domänenwandleiter 1.1 bei der Vorbeifahrt der Magnetanordnung 1.3 entlang der ersten Richtung x ein Magnetfeld einwirkt, dessen Richtung sich in Abhängigkeit von der x-Position ändert. Insbesondere liegen hier quasi drehende beziehungsweise rotierende Magnetfeldlinien beziehungsweise Magnetfeldrichtungen vor. Magnetfeldlinien auf einer Seite der Achse Ay (Figur 7) haben im Vergleich zu Magnetfeldlinien auf der anderen Seite der einen Achse Ay einen entgegengesetzten Drehsinn. Insbesondere haben die Magnetfeldlinien, die bei der Überfahrt die Bereiche A abdecken und die Magnetfeldlinien, die bei der Überfahrt die Bereiche B abdecken, einen entgegengesetzten Drehsinn.

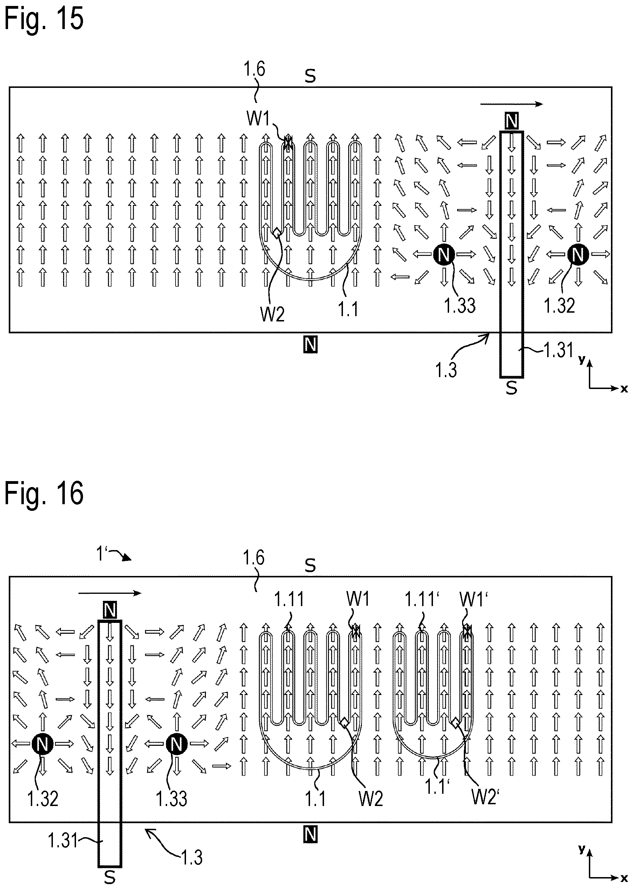

Gemäß einem zweiten Ausführungsbeispiel nach Figur 16 kann ein Sensorelement 1' mehrere Domänenwandleiter 1.1, 1.1' umfassen um die Anzahl der zählbaren Umdrehungen zu erhöhen, wobei die Domänenwandleiter 1.1, 1.1' beispielsweise jeweils eine erste Domänenwand W1, W1' und eine zweite Domänenwand W2, W2' aufweisen. In diesem Fall ist es vorteilhaft, wenn die mehreren Domänenwandleiter 1.1, 1.1' unterschiedliche Anzahlen von ersten Abschnitten 1.11, 1.11` aufweisen, insbesondere unterschiedliche Anzahlen von ersten Bereichen A aufweisen beziehungsweise unterschiedliche Anzahlen von zweiten Bereichen B aufweisen. Bei einer Verwendung von mehreren Domänenwandleitern 1.1, 1.1' ist es von Vorteil, wenn die Anzahlen der ersten Bereiche A der jeweiligen Domänenwandleiter 1.1, 1.1' teilerfremd sind. Die mehreren Domänenwandleiter 1.1, 1.1' können in der ersten Richtung x zueinander versetzt angeordnet sein oder ineinander verschachtelt. In der Figur 16 sind die Domänenwandleiter 1.1, 1.1' so ausgestaltet, dass diese vier und fünf erste Bereiche A aufweisen, wobei in der Figur 16 der Übersichtlichkeit halber Domänenwandleiter 1.1, 1.1' mit vergleichsweise kleinen Anzahlen von ersten Bereichen A gezeigt sind. In der Praxis bietet es sich an Domänenwandleiter mit mehr als nur vier ersten Bereichen A zu verwenden. Beispielsweise können vier Domänenwandleiter verwendet werden mit 7, 9, 11, 13 ersten Bereichen A, so dass dann 9009 (7 x 9 x 11 x 13) Umdrehungen zählbar wären.

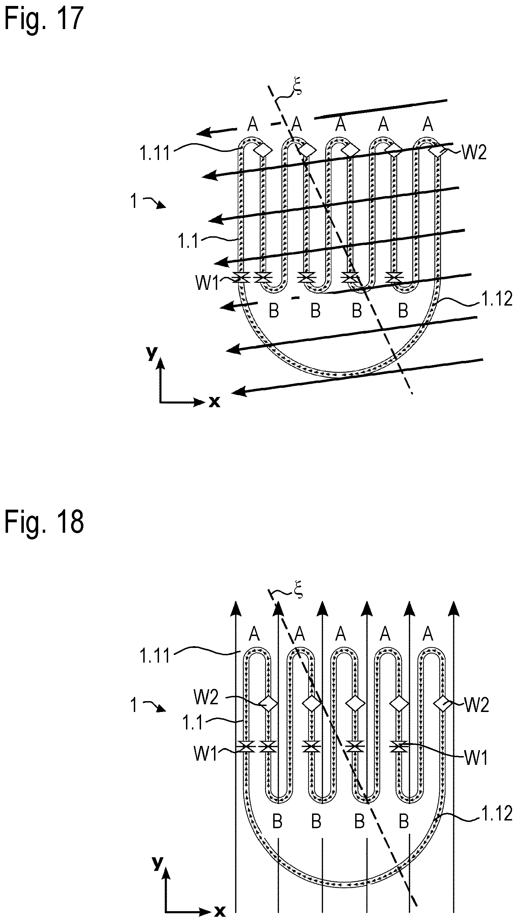

Vor Beginn der Inbetriebnahme, also im Rahmen einer Initialisierung des Speichersystems oder bei einem Reset, soll eine vorgegebene Anzahl von Domänenwänden in definierte Positionen auf dem Domänenwandleiter 1.1, 1.1` gebracht werden. Der Initialisierungs- beziehungsweise Reset-Prozess wird in einer Stellung durchgeführt, in der sich das Sensorelement 1 außerhalb des Einflussbereiches der Magnetanordnung 1.3 befindet. Zunächst wird in einem ersten Prozessschritt eine elektrische Spannung beziehungsweise Potenzialdifferenz an der ersten Kontaktierungsstelle 1.71 und der zweiten Kontaktierungsstelle 1.72 angelegt, beispielsweise kann hierzu ein aufgeladener Kondensator zugeschaltet werden, so dass dessen Entladestrom dann über die erste Kontaktierungsstelle 1.71 und die zweite Kontaktierungsstelle 1.72 fließt. Folglich fließt in der elektrisch leitenden Lage 1.7 des Sensorelements 1 ein elektrischer Strom in einer ersten Stromrichtung ξ , die hier der Richtung einer Verbindungslinie zwischen der ersten Kontaktierungsstelle 1.71 und der zweiten Kontaktierungsstelle 1.72 entspricht. Wie aus der Figur 1a ersichtlich, ist die Achse C um einen Winkel β relativ zur ersten Stromrichtung ξ geneigt ausgerichtet. Im vorgestellten Ausführungsbeispiel beträgt der Winkel β 25°. Durch das vom elektrischen Strom in der elektrisch leitenden Lage 1.7 induzierte Magnetfeld wird also im Domänenwandleiter 1.1 eine Vielzahl von Domänenwänden W1, W2 erzeugt (Figur 17). Dabei ist die Stärke des induzierten Magnetfeldes deutlich größer als das erforderliche Nukleations-Magnetfeld bei dem Domänenwände W1, W2 erzeugt werden. Auch wenn sich das Sensorelement 1 permanent im Magnetfeld des Stützmagneten 1.6 befindet, ist also während des Stromflusses das vom elektrischen Strom induzierte Magnetfeld aufgrund seiner hohen Feldstärke dominant. Entsprechend groß muss der Stromfluss beziehungsweise die Stromstärke in der elektrisch leitenden Lage 1.7 gewählt werden. Im Übrigen sind für diesen Prozess nur sehr kleine Zeiträume erforderlich. Es reicht aus, wenn das vom elektrischen Strom induzierte Magnetfeld weniger als 1 µs anliegt, so dass eine Überhitzung aufgrund der Wärmekapazität des Sensorelements 1 insbesondere des Substrats 1.2 in Verbindung mit einer instationären Wärmeleitung vermieden wird, auch wenn kurzeitig vergleichsweise hohe Ströme flie-ßen. Die sieben großen Pfeile in der Figur 17 sollen das Gesamtmagnetfeld darstellen, das aus einer Überlagerung des Magnetfelds des Stützmagneten 1.6 und des vom elektrischen Strom in der elektrisch leitenden Lage 1.7 erzeugten Magnetfeldes resultiert.

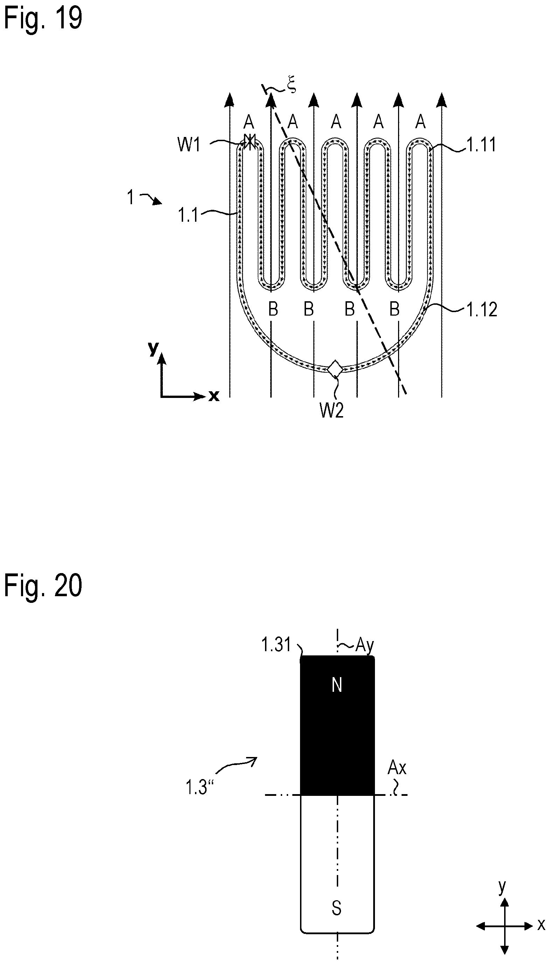

Im nächsten Schritt wird der Stromfluss in der elektrisch leitenden Lage 1.7 unterbunden beziehungsweise unterbrochen, so dass der Domänenwandleiter 1.1 gemäß den Pfeilen in der Figur 18 nur noch dem Magnetfeld des Stützmagneten 1.6 ausgesetzt ist. Dies hat zur Folge, dass die head-to-head-Domänenwände W1 und die tail-to-tail- Domänenwände W2 in den geraden mittleren Bereichen des Domänenwandleiters 1.1 aufeinander zu wandern (Figur 18) und sich schließlich auslöschen (Figur 19). Dann ist der gewünschte definierte Zustand erreicht, in dem die verbleibende erste (head-to-head) Domänenwand W1 in einem ersten Bereich A und die die verbleibende zweite (tail-to-tail) Domänenwand W2 in einem zweiten Bereich B liegen. Die Initialisierung beziehungsweise der Reset des Domänenwandleiters 1.1 ist nun abgeschlossen. Insbesondere ist also der Stützmagnet 1.6 so konfiguriert, dass der Domänenwandleiter 1.1 durch das Magnetfeld des Stützmagneten 1.6 in Überlagerung mit dem Magnetfeld der elektrisch leitenden Lage 1.7 initialisierbar ist.

In der Figur 20 ist ein drittes Ausführungsbeispiel gezeigt, das insbesondere für Anwendungen geeignet ist, bei denen nur wenige Umdrehungen beziehungsweise Durchläufe gezählt werden müssen. In diesem Fall kann die Magnetanordnung 1.3" so vereinfacht werden, dass diese nur einen ersten Magnet 1.31 aufweist. Allerdings kann bei dieser vereinfachten Anordnung die erste Domänenwand W1 nicht durch den zweiten Abschnitt 1.12 des Domänenwandleiters 1.1 mit Hilfe des von der Magnetanordnung 1.3" erzeugten Magnetfeldes geschoben werden. Somit ist in diesem Fall die zählbare Anzahl der Umdrehungen beziehungsweise Durchläufe auf die Anzahl der ersten Abschnitte 1.11 des Domänenwandleiters 1.1 begrenzt. In diesem Ausführungsbeispiel ist es nicht zwingend notwendig, dass der Verlauf des Domänenwandleiters geschlossen umlaufend ausgestaltet ist. Beispielsweise könnte hier auf den Bereich mit dem großen Krümmungsradius, also auf den zweiten Abschnitt des Domänenwandleiters verzichtet werden, so dass der Domänenwandleiter stattdessen zwei Enden aufweist. Zur Stabilisierung der Magnetisierung können dann dort Bereiche mit beispielsweise antiferromagnetischer Kopplung angeordnet werden.

Zur Initialisierung des Speichersystems oder zum Reset des Domänenwandleiters 1.1 für nur vergleichsweise wenige Umdrehungen oder Vorbeifahrten werden zunächst die gleichen Schritte vorgenommen wie beim ersten Ausführungsbeispiel. Entsprechend befindet sich der Domänenwandleiter 1.1 in dem definierten Zustand, in dem eine Domänenwand W1 in einem ersten Bereich A in einem ersten Abschnitt 1.11 und die zweite Domänenwand W2 im zweiten Abschnitt 1.12 liegen, gemäß der Figur 19. Für ein Sensorelement 1, mit dem nur wenige Umdrehungen oder Vorbeifahrten gezählt werden müssen, ist es vorteilhaft, dass die erste Domänenwand W1 möglichst in dem in der Mitte liegenden ersten Bereich A beziehungsweise ersten Abschnitt 1.11 zu liegen kommt.

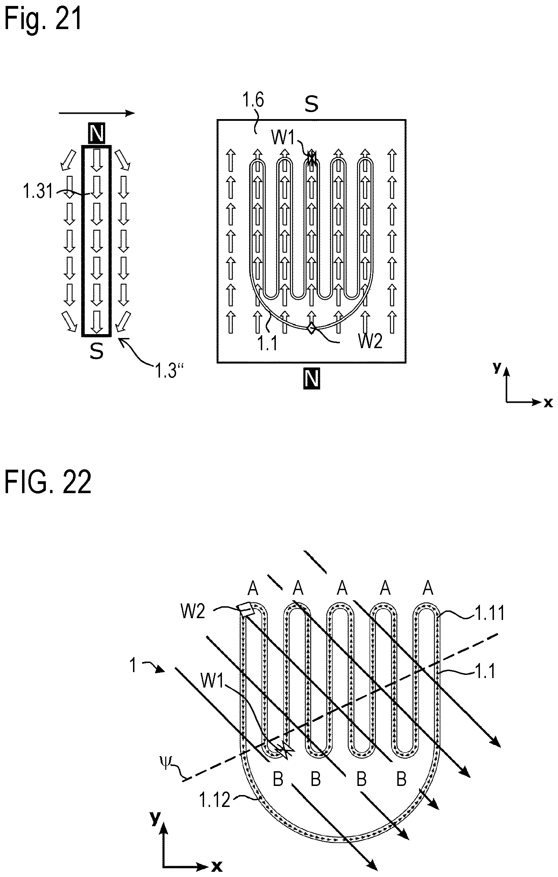

Auch der nun folgende Prozessschritt wird durchgeführt, wenn sich das Sensorelement 1 außerhalb des Einflussbereiches der Magnetanordnung 1.3 befindet, aber im Einflussbereich des Stützmagneten 1.6. Damit die erste Domänenwand W1 aus der Position gemäß der Figur 19 verschoben wird, wird nun eine elektrische Spannung beziehungsweise Potenzialdifferenz an der dritten Kontaktierungsstelle 1.73 und der vierten Kontaktierungsstelle 1.74 angelegt. Dies hat zur Folge, dass in der elektrisch leitenden Lage 1.7 des Sensorelements 1 ein elektrischer Strom in einer zweiten Stromrichtung ψ fließt. Im Vergleich zum vorher erzeugten Strom zwischen der ersten und zweiten Kontaktstelle 1.71, 1.72 ist die nun eingeprägte Stromstärke geringer. Allerdings wird nun der Stromfluss länger aufrechterhalten (einige µs) als zuvor. Danach kommen die Domänenwände W1, W2 in Positionen gemäß der Figur 22 zu liegen. Die sieben großen Pfeile in der Figur 22 sollen das Gesamtmagnetfeld darstellen, das aus einer Überlagerung des Magnetfelds des Stützmagneten 1.6 und des vom elektrischen Strom in der elektrisch leitenden Lage 1.7 erzeugten Magnetfeldes resultiert.

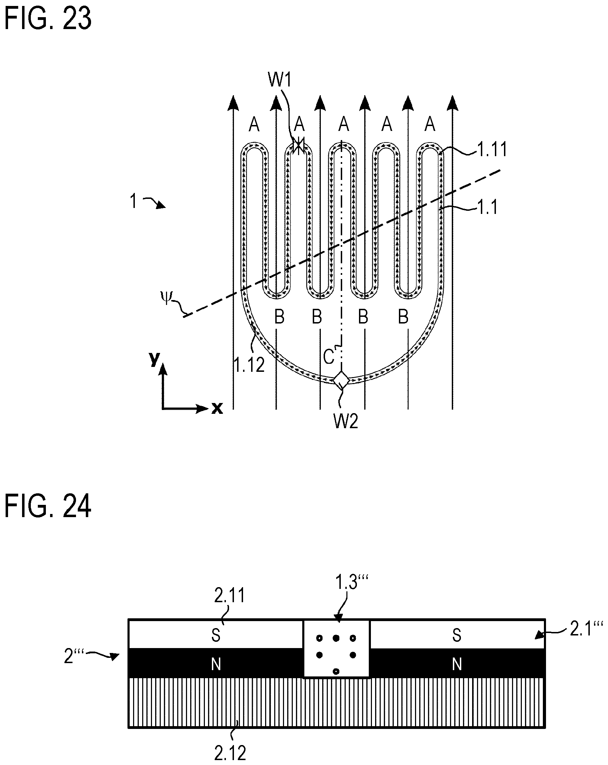

Danach wird der Stromfluss unterbunden, so dass der Domänenwandleiter 1.1 nur noch dem Magnetfeld des Stützmagneten 1.6 ausgesetzt ist. Die Domänenwände W1, W2 bewegen sich unter diesen Bedingungen in Positionen gemäß der Figur 23.

Diese beiden letztgenannten Prozessschritte können nun wiederholt werden bis die erste Domänenwand W1 im mittigen ersten Bereich A zu liegen kommt und die zweite Domänenwand W2 mittig im zweiten Abschnitt 1.12. In diesem Zustand, der in den Figuren nicht explizit dargestellt ist, liegen dann die Domänenwände W1, W2 auf der Achse C und es können nun die maximale Anzahl von Umdrehungen beziehungsweise Vorbeifahrten in beiden Bewegungsrichtungen gezählt werden.

In den bislang vorgestellten Ausführungsbeispielen ist das Speichersystem so ausgestaltet, dass der Stützmagnet 1.6 relativ zum Sensorelement 1 unbeweglich angeordnet ist, wobei der Stützmagnet 1.6 so angeordnet ist, dass sich das Sensorelement 1 zwischen der Magnetanordnung 1.3, 1.3" und dem Stützmagnet 1.6 befindet.

Gemäß einem vierten Ausführungsbeispiel, siehe Figur 24, kann alternativ ein Stützmagnet 2.11 an einem Bauteil 2‴ angeordnet sein, wobei das Bauteil 2‴ ansonsten ähnlich ausgestaltet ist wie in den ersten drei Ausführungsbeispielen. Allerdings umfasst die Magnetanordnung 1.3‴ hier ein Magnet-Array aus mehreren (Permanent-) Magneten. Zudem weist die Trommel 2.1‴ im Bereich des Außenumfangs den Stützmagneten 2.11 auf. Dieser kann beispielsweise aus einer Schicht aus magnetisierbarem Material bestehen. Die Magnetisierung ist so vorgenommen, dass Nord- und Südpol axial versetzt zueinander angeordnet sind. In der zweiten Richtung y, also in axialer Richtung versetzt zum Stützmagneten 2.11, ist auch hier eine feine Skala 2.12 umlaufend auf der Trommel 2.1‴aufgebracht.

## Patentansprüche

1. Sensorelement (1; 1') zur Speicherung von Umdrehungs- oder Positionsinformationen, wobei das Sensorelement (1; 1')
¬ einen Domänenwandleiter (1.1; 1.1') umfasst, der auf einem Substrat (1.2) angeordnet ist, wobei der Verlauf des Domänenwandleiters (1.1; 1.1') kreuzungsfrei ausgestaltet ist und der Domänenwandleiter (1.1; 1.1') einen ersten Bereich (A) mit einer positiven Krümmung und einen zweiten Bereich (B) mit einer negativen Krümmung aufweist,
¬ eine elektrisch leitende Lage (1.7) umfasst, die auf dem Substrat (1.2) aufgebracht ist und die relativ zum Domänenwandleiter (1.1; 1.1') überlappend und gegenüber diesem elektrisch isoliert angeordnet ist, wobei die elektrisch leitende Lage (1.7) vier Kontaktierungsstellen (1.71, 1.72, 1.73, 1.74) aufweist, die so angeordnet sind, dass
an zwei Paaren von Kontaktierungsstellen (1.71, 1.72, 1.73, 1.74) eine elektrische Spannung anlegbar ist, so dass ein elektrischer Strom wahlweise in einer ersten Stromrichtung (ξ) oder in einer zweiten Stromrichtung (ψ) fließt, wobei die erste Stromrichtung (ξ) orthogonal zur zweiten Stromrichtung (ψ) orientiert ist, so dass durch das vom Strom induzierte Magnetfeld im Domänenwandleiter (1.1; 1.1') Domänenwände (W1, W2, W1', W2') erzeugbar sind.

2. Sensorelement (1; 1') gemäß einem der vorhergehenden Ansprüche, wobei der Verlauf des Domänenwandleiters bezüglich einer Achse (C) achsensymmetrisch ausgestaltet ist.

3. Sensorelement (1; 1') gemäß dem Anspruch 2, wobei die Achse (C) um einen Winkel (β) relativ zur ersten Stromrichtung (ξ) geneigt ausgerichtet ist.

4. Sensorelement (1; 1') gemäß dem Anspruch 3, wobei der Winkel (β) größer ist als 10° und kleiner als 60°.

5. Sensorelement (1; 1') gemäß einem der vorhergehenden Ansprüche, wobei der Verlauf des Domänenwandleiters (1.1; 1.1') geschlossen umlaufend ausgestaltet ist.

6. Sensorelement (1; 1') gemäß einem der vorhergehenden Ansprüche, wobei der Verlauf des Domänenwandleiters (1.1; 1.1') stetig ausgestaltet ist.

7. Sensorelement (1; 1') gemäß einem der vorhergehenden Ansprüche, wobei das Sensorelement (1; 1') weiterhin Ausleseelemente (3) aufweist, durch die der lokale Magnetisierungszustand des Domänenwandleiters (1.1; 1.1') bestimmbar ist.

8. Sensorelement (1; 1') gemäß dem Anspruch 7, wobei die Ausleseelemente (3) als GMR- oder TMR-Sensoren ausgestaltet sind.

9. Sensorelement (1') gemäß einem der vorhergehenden Ansprüche, wobei das Sensorelement (1') mehrere Domänenwandleiter (1.1; 1.1') aufweist, welche unterschiedliche Anzahlen von ersten Bereichen (A) oder unterschiedliche Anzahlen von zweiten Bereichen (B) aufweisen.

10. Sensorelement (1') gemäß dem Anspruch 9, wobei die unterschiedlichen Anzahlen ersten Bereichen (A) teilerfremd sind.

11. Speichersystem, welches ein Sensorelement (1; 1') gemäß dem Anspruch 1, ein Bauelement (2) und einen Stützmagnet (1.6, 2.11) umfasst, wobei
- das Bauelement (2) eine Magnetanordnung (1.3; 1.3"; 1.3‴) umfasst, welches in einer ersten Richtung (x) relativ zum Domänenwandleiter (1.1; 1.1') bewegbar ist,
- der Stützmagnet (1.6, 2.11),
¬ relativ zum Sensorelement (1; 1') unbeweglich angeordnet ist oder
¬ bezogen auf die erste Richtung (x) neben der Magnetanordnung (3) am Bauelement (2) angeordnet ist, wobei
der Stützmagnet (1.6, 2.11) so konfiguriert ist, dass der Domänenwandleiter (1.1; 1.1') durch das Magnetfeld des Stützmagneten (1.6, 2.11) in Überlagerung mit dem Magnetfeld der elektrisch leitenden Lage (1.7) initialisierbar ist.

12. Speichersystem gemäß dem Anspruch 11, wobei das Sensorelement (1; 1') zwischen der Magnetanordnung (1.3; 1.3") und dem Stützmagnet (1.6) angeordnet ist.

13. Speichersystem gemäß dem Anspruch 11 oder 12, wobei der Stützmagnet (1.6, 2.11) so angeordnet ist, dass eine Verbindungslinie zwischen dessen Nordpol und dessen Südpol in einer zweiten Richtung (y) orientiert ist, wobei diese eine Komponente orthogonal zur ersten Richtung (x) aufweist.

## Claims

1. Sensor element (1; 1') for storing rotation or position information, wherein the sensor element (1; 1')
- comprises a domain wall conductor (1.1; 1.1') which is arranged on a substrate (1.2), wherein the course of the domain wall conductor (1.1; 1.1') is without crossings and the domain wall conductor (1.1; 1.1') has a first region (A) with a positive curvature and a second region (B) with a negative curvature,
- comprises an electrically conductive layer (1.7) which is applied to the substrate (1.2) and is arranged in an overlapping manner relative to the domain wall conductor (1.1; 1.1') and so as to be electrically insulated with respect to the latter, wherein the electrically conductive layer (1.7) has four contact points (1.71, 1.72, 1.73, 1.74) which are arranged such that
two pairs of contact points (1.71, 1.72, 1.73, 1.74) can have a voltage applied to them, with the result that an electric current flows either in a first current direction (ξ) or in a second current direction (Ψ), the first current direction (ξ) being oriented orthogonally with respect to the second current direction (Ψ), with the result that the magnetic field induced by the current can generate domain walls (W1, W2, W1', W2') in the domain wall conductor (1.1; 1.1').

2. Sensor element (1; 1') according to one of the preceding claims, wherein the course of the domain wall conductor is axially symmetrical with respect to an axis (C).

3. Sensor element (1; 1') according to Claim 2, wherein the axis (C) is aligned so as to be inclined by an angle (β) relative to the first current direction (ξ).

4. Sensor element (1; 1') according to Claim 3, wherein the angle (β) is greater than 10° and less than 60°.

5. Sensor element (1; 1') according to one of the preceding claims, wherein the course of the domain wall conductor (1.1; 1.1') is closed circumferentially.

6. Sensor element (1; 1') according to one of the preceding claims, wherein the course of the domain wall conductor (1.1; 1.1') is continuous.

7. Sensor element (1; 1') according to one of the preceding claims, wherein the sensor element (1; 1') also has read-out elements (3) which can be used to determine the local magnetization state of the domain wall conductor (1.1; 1.1').

8. Sensor element (1; 1') according to Claim 7, wherein the read-out elements (3) are in the form of GMR or TMR sensors.

9. Sensor element (1') according to one of the preceding claims, wherein the sensor element (1') has a plurality of domain wall conductors (1.1; 1.1') having different numbers of first regions (A) or different numbers of second regions (B).

10. Sensor element (1') according to Claim 9, wherein the different numbers of first regions (A) are coprime.

11. Storage system comprising a sensor element (1; 1') according to Claim 1, a component (2) and a supporting magnet (1.6, 2.11), wherein
- the component (2) comprises a magnet arrangement (1.3; 1.3"; 1.3‴) which can be moved in a first direction (x) relative to the domain wall conductor (1.1; 1.1'),
- the supporting magnet (1.6, 2.11)
- is arranged immovably relative to the sensor element (1; 1') or
- is arranged beside the magnet arrangement (3) on the component (2) based on the first direction (x), wherein
the supporting magnet (1.6, 2.11) is configured such that the domain wall conductor (1.1; 1.1') can be initialized in a manner superimposed with the magnetic field of the electrically conductive layer (1.7) by the magnetic field of the supporting magnet (1.6, 2.11).

12. Storage system according to Claim 11, wherein the sensor element (1; 1') is arranged between the magnet arrangement (1.3; 1.3'') and the supporting magnet (1.6).

13. Storage system according to Claim 11 or 12, wherein the supporting magnet (1.6, 2.11) is arranged such that a connecting line between its north pole and its south pole is oriented in a second direction (y), wherein the latter has a component orthogonal to the first direction (x).

## Revendications

1. Élément capteur (1 ; 1') destiné à mémoriser des informations de rotation ou de position, l'élément capteur (1 ; 1')
- comportant un conducteur de paroi de domaine (1.1 ; 1.1'), qui est disposé sur un substrat (1.2), le tracé du conducteur de paroi de domaine (1.1 ; 1.1') étant configuré sans intersection et le conducteur de paroi de domaine (1.1 ; 1.1') possédant une première zone (A) avec une courbure positive et une deuxième zone (B) avec une courbure négative,
- comportant une couche (1.7) électriquement conductrice, qui est appliquée sur le substrat (1.2) et qui est disposée en chevauchement par rapport au conducteur de paroi de domaine (1.1 ; 1.1') et isolée électriquement de celui-ci, la couche (1.7) électriquement conductrice possédant au moins quatre points d'établissement de contact (1.71, 1.72, 1.73, 1.74), qui sont disposés de telle sorte que
une tension électrique peut être appliquée à deux paires de points d'établissement de contact (1.71, 1.72, 1.73, 1.74), de telle sorte qu'un courant électrique circule, au choix, dans une première direction de courant (ξ) ou dans une deuxième direction de courant (ψ), la première direction de courant (ξ) étant orientée orthogonalement à la deuxième direction de courant (ψ), de sorte que des parois de domaine (W1, W2, W1', W2') peuvent être générées par le champ magnétique induit par le courant dans le conducteur de paroi de domaine (1.1 ; 1.1').

2. Élément capteur (1 ; 1') selon l'une des revendications précédentes, le tracé du conducteur de paroi de domaine étant configuré avec symétrie axiale par rapport à un axe (C).

3. Élément capteur (1 ; 1') selon la revendication 2, l'axe (C) étant orienté incliné selon un certain angle (β) par rapport à la première direction de courant (ξ).

4. Élément capteur (1 ; 1') selon la revendication 3, l'angle (β) étant supérieur à 10° et inférieur à 60°.

5. Élément capteur (1 ; 1') selon l'une des revendications précédentes, le tracé du conducteur de paroi de domaine (1.1 ; 1.1') étant configuré circulaire fermé.

6. Élément capteur (1 ; 1') selon l'une des revendications précédentes, le tracé du conducteur de paroi de domaine (1.1 ; 1.1') étant configuré continu.

7. Élément capteur (1 ; 1') selon l'une des revendications précédentes, l'élément capteur (1 ; 1') possédant en outre des éléments de lecture (3) par le biais desquels peut être déterminé l'état de magnétisation local du conducteur de paroi de domaine (1.1 ; 1.1').

8. Élément capteur (1 ; 1') selon la revendication 7, les éléments de lecture (3) étant réalisés sous la forme de capteurs GMR ou TMR.

9. Élément capteur (1') selon l'une des revendications précédentes, l'élément capteur (1') possédant plusieurs conducteurs de paroi de domaine (1.1 ; 1.1'), lesquels possèdent des nombres différents de premières zones (A) ou des nombres différents de deuxièmes zones (B).

10. Élément capteur (1') selon la revendication 9, les nombres différents de premières zones (A) étant non divisibles.

11. Système de mémoire, lequel comporte un élément capteur (1 ; 1') selon la revendication 1, un élément structural (2) et un aimant de soutien (1.6, 2.11),
- l'élément structural (2) comportant un arrangement d'aimants (1.3 ; 1.3' ' ; 1.3‴) qui peut être déplacé dans une première direction (x) par rapport au conducteur de paroi de domaine (1.1 ; 1.1'),
- l'aimant de soutien (1.6, 2.11)
- étant disposé immobile par rapport à l'élément capteur (1 ; 1') ou
- en référence à la première direction (x), étant disposé à côté de l'arrangement d'aimants (3) sur l'élément structural (2),
l'aimant de soutien (1.6, 2.11) étant configuré de telle sorte que le conducteur de paroi de domaine (1.1 ; 1.1') peut être initialisé par le champ magnétique de l'aimant de soutien (1.6, 2.11) en superposition avec le champ magnétique de la couche (1.7) électriquement conductrice.

12. Système de mémoire selon la revendication 11, l'élément capteur (1 ; 1') étant disposé entre l'arrangement d'aimants (1.3 ; 1.3'') et l'aimant de soutien (1.6).

13. Système de mémoire selon la revendication 11 ou 12, l'aimant de soutien (1.6, 2.11) étant disposé de telle sorte qu'une ligne de liaison entre son pôle nord et son pôle Sud est orientée dans une deuxième direction (y), celle-ci possédant une composante orthogonale à la première direction (x).
